Europäisches Patentamt

**European Patent Office**

Office européen des brevets

(19)

(11) Veröffentlichungsnummer: **0 029 903**
**B1**

(12)

# EUROPÄISCHE PATENTSCHRIFT

(45) Veröffentlichungstag der Patentschrift:
14.03.84

(21) Anmeldenummer: 80106273.8

(22) Anmeldetag: 15.10.80

(51) Int. Cl.³: **G 01 R 17/02**, G 01 R 19/00,
H 01 F 40/00

(54) **Messanordnung für elektrische Ströme.**

(30) Priorität: 30.11.79 DD 217290

(43) Veröffentlichungstag der Anmeldung:
10.06.81 Patentblatt 81/23

(45) Bekanntmachung des Hinweises auf die Patenterteilung:
14.03.84 Patentblatt 84/11

(84) Benannte Vertragsstaaten:
AT CH DE FR GB IT LI SE

(56) Entgegenhaltungen:
DE - A - 2 632 377
DE - A - 2 812 303
DE - B - 1 076 260
DE - C - 603 514
US - A - 2 358 480

(73) Patentinhaber: **VEB Transformatoren- und Röntgenwerk "Hermann Matern", Overbeckstrasse 48, DDR-8030 Dresden (DD)**
Patentinhaber: **Institut "Prüffeld für elektrische Hochleistungstechnik", Leninallee 376, DDR-1130 Berlin (DD)**

(72) Erfinder: **Brendler, Werner, Prof. Dr., Erlweinstrasse 6, DDR-8027 Dresden (DD)**
Erfinder: **Ermisch, Jochen, Dr.-Ing., Sidonienstrasse 5, DDR-8122 Radebeul (DD)**

(74) Vertreter: **Patentanwälte Beetz sen. - Beetz jun. Timpe - Siegfried - Schmitt-Fumian, Steinsdorfstrasse 10, D-8000 München 22 (DE)**

### Meßanordnung für elektrische Ströme

Die Erfindung betrifft eine Meßanordnung für elektrische Ströme. Diese ist insbesondere für solche Ströme vorgesehen, die sich wegen ihrer Stärke bzw. des an den Stromleitern herrschenden Potentials nicht unmittelbar meßtechnisch erfassen lassen.

Zur Wandlung von hohen Strömen in solche, die der Messung unmittelbar zugänglich sind, werden Stromwandler verwendet. In herkömmlicher Ausführung bestehen diese aus der vom zu messenden Strom durchflossenen Primärwicklung, dem Magnetkern und der Sekundärwicklung, die mit einer Bürde abgeschlossen ist. Die Sekundärwicklung führt einen dem Primärstrom entsprechenden, durch das Übersetzungsverhältnis bestimmten Strom. Das reale Verhältnis zwischen Primär- und Sekundärstrom zeigt jedoch hiervon Abweichungen, die als Wandlerfehler bezeichnet werden. Dieser Wandlerfehler ist bürdenabhängig und sinkt mit abnehmender Bürdenimpedanz. Da die Strommessung jedoch eine bestimmte Leistungsaufnahme im Sekundärkreis bedingt, kann die Bürde nicht beliebig klein gewählt werden. Geringe Wandlerfehler erfordern daher die entsprechende Berücksichtigung anderer, den Fehler beeinflussender Parameter. So wird beispielsweise ein Magnetkern mit hoher Anfangspermeabilität verwendet. Zur Verringerung des Wandlerfehlers über den durch die Materialeigenschaften und technischen Gestaltungsmöglichkeiten gesteckten Rahmen hinaus ist eine Vielzahl von sogenannten Kunstschaltungen bekanntgeworden, die entweder nur mit passiven oder auch mit aktiven Elementen ausgeführt sind.

So ist ein fehlerkompensierter Meßwandler bekannt, bei dem die bürdenabhängigen Verluste weitgehend kompensiert werden (DE-B1-1 303 532). Dies erfolgt mit Hilfe eines rückgekoppelten Verstärkers und eines induktiven Kopplungselements. Das Kopplungselement stellt eine sogenannte magnetische Nachbildung des Meßwandlers dar, d. h., das Material beider Magnetkerne besitzt die gleiche Magnetisierungscharakteristik. Durch Vergleich der aussteuerungsabhängigen Spannungen von Wandler und induktivem Kopplungselement speist der Verstärker die Leistung der inneren Bürde des Wandlers zusätzlich in den Wandler ein und kompensiert somit den auftretenden Fehler. Der Verstärker deckt damit nicht die Meßleistung des Wandlers. Der eigentliche Meßwandler muß daher für die aufzubringende Bürdenleistung dimensioniert werden. Dem Bedürfnis der richtigen Erfassung höherer Kurzschlußströme kann dabei ebenfalls nur durch vergrößerten Materialaufwand Rechnung getragen werden.

Es sind des weiteren Stromwandler mit elektronischer Fehlerkompensation bekannt, bei denen in den Sekundärkreis eine solche Spannung eingespeist wird, daß die Induktion im Wandler gegen Null geht. Ein solcher Wandler ist hinsichtlich seines Fehlerverhaltens praktisch unabhängig von Strom- und Bürdenänderungen, weil die Bürdenleistung von einem Verstärker aufgebracht wird und der Wandler in einem konstanten magnetischen Arbeitspunkt ausgesteuert ist. Derartige Stromwandler, die auch als Stromkomparatoren bezeichnet werden, weisen eine relativ hohe Genauigkeit bei geringem Eigengewicht auf. Als Indikatoren für die zum Verschwinden zu bringende Induktion werden Indikatorwicklungen oder Hallsonden verwendet (DE-A1-2 632 377 und DE-A1-2 621 302). Dabei müssen jedoch konstruktive Ausführungen gewählt werden, die nur eine minimale Streuung aufweisen. Weiterhin ist es mit diesem Meßprinzip nicht möglich, bereits eingebaute, in Betrieb befindliche Stromwandler zu verbessern.

Des weiteren ist bekannt, zur Strommessung magnetische Spannungsmesser einzusetzen und diese an ihrem Ausgang mit einem Integrierglied zu beschalten. Anstelle des Integrierglieds wird in der DE-A1-2 812 303 eine Schaltungsanordnung mit einem Differenzverstärker beschrieben, die durch Anwendung von zwei magnetischen Spannungsmessern und Vergleich ihrer Differentialquotienten einen Ausgangsstrom liefert, der dem zu messenden Strom proportional ist. Wie alle magnetischen Spannungsmesser ist auch diese Meßanordnung leicht von Fremdfeldern beeinflußbar.

Der Erfindung liegt die Aufgabe zugrunde, eine Anordnung zur Messung elektrischer Ströme, insbesondere auf Hochspannungspotential, anzugeben, die bei geringem Materialeinsatz eine sehr hohe Meßgenauigkeit, auch im Überstrombereich gewährleistet.

Diese Aufgabe wird erfindungsgemäß mit einer Meßanordnung gemäß Anspruch 1 oder 3 und zwar mit Hilfe zweier Magnetkernübertrager von zumindest annähernd gleichem Übertragungsverhalten gelöst, deren Sekundärwicklungen miteinander zu einem Stromkreis verbunden sind, wobei die Primärwicklung des ersten Übertragers vom zu messenden Strom und die Primärwicklung des zweiten Übertragers von einem dem zu messenden Strom proportionalen Strom durchflossen sind. Des weiteren arbeitet auf die Primärwicklung des zweiten Übertragers ein aktiver Vierpol, der von einer dem Stromkreis der Sekundärwicklungen entnommenen Differenzgröße gesteuert wird. Der aktive Vierpol ist vorzugsweise als Differenzverstärker ausgebildet und mit seinen Eingängen an die Verbindungen der beiden Sekundärwicklungen geschaltet.

Für die Erfassung sehr hoher Stromstärken ist nach einer erfindungsgemäßen Weiterbildung jeder Übertrager mit einer zusätzlichen, zweiten Sekundärwicklung ausgestattet. Diese zusätzlichen Sekundärwicklungen sind derart gegeneinandergeschaltet, daß die einen Wicklungsenden galvanisch verbunden und die anderen Wicklungsenden an die Eingänge des aktiven Vierpols gelegt sind. Besonders günstige Ausführ- und Anwendungsmöglichkeiten ergeben sich, wenn der erste, vom zu messenden Strom durchflossene Übertrager als Einleiterstromwandler mit einem Ringkern ausgeführt ist.

Für die Belange der Gleichstrommessung ist ebenfalls für jeden Übertrager eine zusätzliche Sekundärwicklung vorgesehen, wobei die Sekundärwicklungen von einem Frequenzgenerator gespeist werden.

Für automatisierte Meßplätze und/oder eine digitale Signalverarbeitung kann die gewünschte Abbildung des Primärstroms als Gleichstromgröße auf vorteilhafte Weise dadurch erreicht werden, daß mit der Primärwicklung des zweiten Übertragers eine Gleichrichterbrücke mit Gleichstromindikator, z. B. in Gestalt einer Graetz-Brücke, in Reihe geschaltet ist.

Im Zusammenhang mit der Überwachung von Mehrleitersystemen kann es günstig sein, den ersten Übertrager in der Art eines Nullstromwandlers auszubilden.

Eine gegebenenfalls notwendige Potentialtrennung zwischen dem aktiven Vierpol und dem Wechselstromindikator kann dadurch erreicht werden, daß ein weiterer Übertrager vorgesehen ist, auf den der aktive Vierpol arbeitet und dessen Sekundärwicklung in Reihe mit der Primärwicklung des zweiten Übertragers liegt.

Die besonderen Vorteile der Erfindung bestehen in einer gegenüber konventionellen Stromwandlern prinzipiell verbesserten Meßgenauigkeit durch Vermeidung bürdenabhängiger Übertragungsfehler sowie darin, daß der Einsatz an Kern- und Wicklungsmaterial wesentlich vermindert und auf die Verwendung hochpermeablen Kernmaterials verzichtet werden kann.

Anhand eines Ausführungsbeispiels soll die Erfindung näher erläutert werden. In den zugehörigen Zeichnungen zeigt

Fig. 1 die Grundschaltung der erfindungsgemäßen Meßanordnung für elektrische Ströme,

Fig. 2 eine Steuermöglichkeit für den Differenzverstärker,

Fig. 3 eine für Gleichstrommessungen modifizierte Meßanordnung,

Fig. 4 eine Meßanordnung mit einem Ausgang, der Gleichstromsignale liefert,

Fig. 5 eine Meßanordnung, die nach Art eines Nullstromwandlers modifiziert wurde, und

Fig. 6 eine Meßanordnung mit Potentialtrennung zwischen Meßkreis und Differenzverstärker.

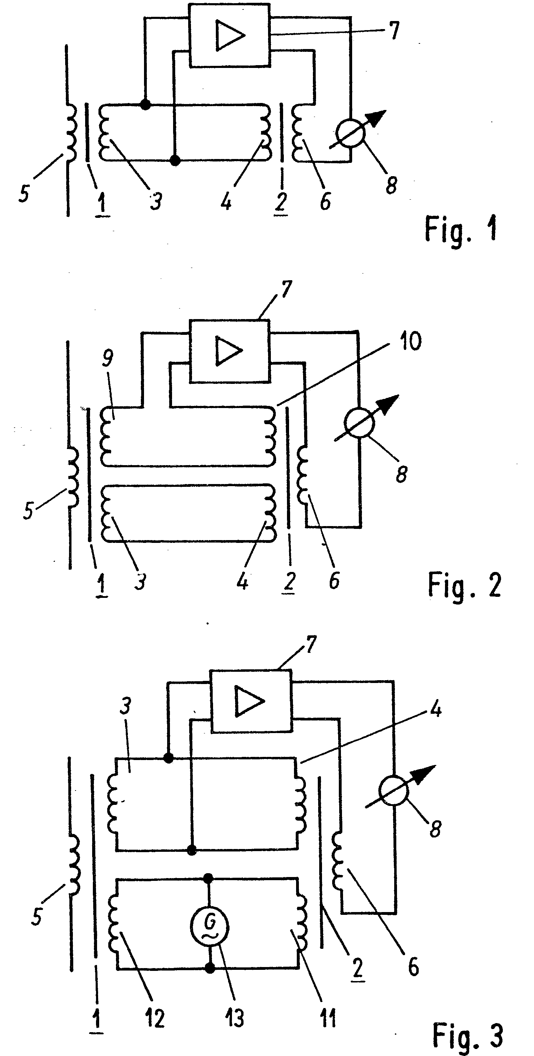

Fig. 1 zeigt die prinzipielle Schaltungsanordnung gemäß der Erfindung. Die Meßanordnung besteht aus zwei Übertragern 1; 2, deren Sekundärwicklungen 3; 4 zu einem Stromkreis zusammengeschaltet sind. Die Primärwicklung 5 des ersten Übertragers 1 wird von dem zu messenden Strom durchflossen, während die Primärwicklung 6 des zweiten Übertragers 2 von einem Differenzverstärker 7 gespeist wird. Der Differenzverstärker 7 ist mit seinen Eingängen an die beiden Verbindungen der Sekundärwicklungen 3; 4 gelegt. In Reihe mit der Primärwicklung 6 des zweiten Übertragers 2 ist ein Wechselstromindikator 8 angeordnet. Beide Übertrager 1; 2 weisen weitgehend gleiches Übertragungsverhalten auf, d. h. sie arbeiten in ihrem gesamten Aussteuerbereich mit im wesentlichen gleicher magnetischer Induktion.

Wird die Primärwicklung 5 des ersten Übertragers 1 von einem zu messenden Strom durchflossen, so gibt der Differenzverstärker 7 auf die Primärwicklung 6 des zweiten Übertragers 2 einen Strom ab, der so groß ist, daß sich zwischen den beiden Verbindungen der Sekundärwicklungen 3; 4 eine Spannung nahe Null einstellt. In beiden Übertragern 1; 2 herrscht nun die gleiche auf die Länge des magnetischen Weges bezogene Durchflutung. Da voraussetzungsgemäß beide Übertrager 1; 2 eine im wesentlichen gleiche Charakteristik aufweisen und die Ströme in den Sekundärwicklungen 3; 4 gleich sind, muß der Strom, der die Primärwicklung 6 des zweiten Übertragers 2 durchfließt, proportional dem Betrag des zu messenden Stromes und in Phase mit ihm sein. Da die Bürdenleistung für den Wechselstromindikator 8 vom Differenzverstärker 7 aufgebracht wird, hat der Betrag der Bürde keinen Einfluß auf das Übertragungsverhalten der Meßanordnung, solange der Differenzverstärker 7 die Meßleistung aufbringen kann.

Der erste Übertrager 1 ist vorzugsweise als Einleiterwandler mit Ringkern ausgeführt, da dieser nur als Signalgeber ohne wesentliche Leistungsübertragung wirkt. Im Gegensatz zum Stromwandler herkömmlicher Art können die Übertrager 1; 2 mit extrem geringem Materialaufwand ausgeführt werden, da die meßtechnisch und leistungsmäßig begründeten bisherigen baulichen Bedingungen entfallen. Beide Übertrager 1; 2 müssen nur etwa gleiche Charakteristik aufweisen. Diese Bedingung ist erfüllt, wenn beide Wandler mit gleichem Magnetwerkstoff ausgerüstet sind, im Nennarbeitsbereich gleiche Werte der Induktion aufweisen und beide Wandler in der Dimensionierung (Primärstrom × Primärwindungszahl mittlere Kernweglänge) gleich sind.

Fig. 2 zeigt eine andere Möglichkeit für die Steuerung des Differenzverstärkers 7. Hierbei enthalten beide Übertrager 1; 2 jeweils eine weitere Sekundärwicklung 9; 10, die auch als Indikatorwicklungen bezeichnet werden kann. Die weiteren Sekundärwicklungen 9; 10 sind mit ihren einen Wicklungsenden miteinander verbunden; und die jeweils anderen Wicklungsenden liegen am Eingang des Differenzverstärkers 7. Durch diese Anordnung wird der Differenzverstärker 7 von der zwischen beiden Übertragern herrschenden Differenz der Induktion gesteuert. Diese erfindungsgemäße Möglichkeit kommt insbesondere für hohe Stromstärken in Frage, wenn die Dimensionierung des Übersetzungsverhältnisses zwischen dem Strom in der Primärwicklung 5 des ersten Übertragers 1 und dem Strom durch die Sekundärwicklungen 3; 4 problematisch ist. Ebenfalls für hohe Stromstär-

ken eignet sich eine Anordnung, bei der analog zu Fig. 1 die weiteren Sekundärwicklungen zu einem Stromkreis zusammengeschaltet und die Eingänge des Differenzverstärkers an die beiden Verbindungen gelegt sind.

In Fig. 3 ist eine für Gleichstrommessungen modifizierte Schaltungsanordnung gezeigt. Beide Übertrager 1; 2 sind mit jeweils einer weiteren Wicklung 11; 12 ausgeführt; diese weiteren Wicklungen sind von einem Frequenzgenerator 13 gespeist. Dadurch wird in den Übertragern 1; 2 eine Aussteuerung erzwungen. Ohne Strom durch die Primärwicklung 5 des ersten Übertragers 1 sind die Aussteuerungen der Magnetkreise der Übertrager 1; 2 gleich, d. h., die Spannung zwischen den Klemmen des Differenzverstärkers 7 ist Null, und es fließt kein Strom durch die Primärwicklung 6 des zweiten Übertragers 2. Bei einer zusätzlichen Aussteuerung des Übertragers 1 durch einen Strom in der Primärwicklung 5 ändert sich die Spannung zwischen den Klemmen des Differenzverstärkers 7, und es fließt durch die Primärwicklung 6 des zweiten Übertragers 2 ein Strom, dessen Mittelwert dem Strom in der Primärwicklung 5 des ersten Übertragers 1 entspricht.

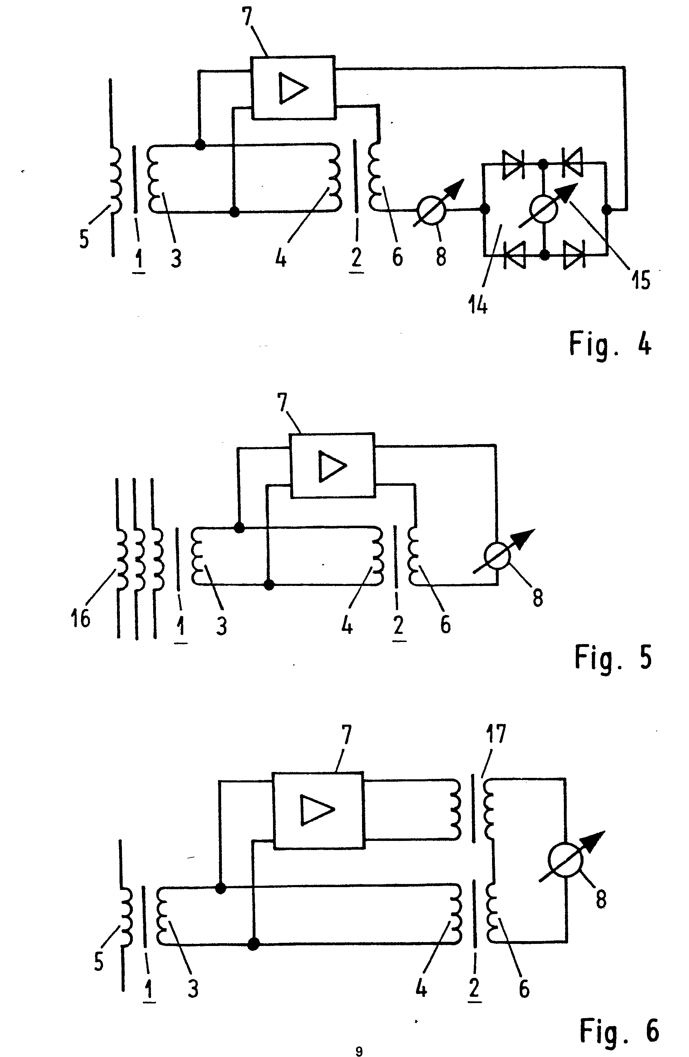

Fig. 4 zeigt eine Schaltungsanordnung, bei der zur Anwendung in automatisierten Meßplätzen und/oder zur digitalen Signalverarbeitung die Abbildung des Primärstromes als Gleichstromgröße möglich ist. Dazu ist die Primärwicklung 6 des zweiten Übertragers 2 mit einem Brückengleichrichter 14 mit einem Gleichstromindikator 15 in Reihe geschaltet. Der Brückengleichrichter 14 kann in Graetz-Schaltung ausgeführt sein. Da zur Erzielung eines gleichen Aussteuerpunktes in den Übertragern 1; 2 ein Strom durch die Primärwicklung 6 des zweiten Übertragers 2 fließen muß, der dem Strom in der Primärwicklung 5 des ersten Übertragers 1 entspricht und nicht von zusätzlichen Schaltelementen im Ausgangsstromkreis des Differenzverstärkers 7 bestimmt wird, ist auch der Strom durch den Gleichstromindikator 15 unabhängig von der Kennlinie der verwendeten Gleichrichterdioden repräsentativ für den Gleichrichtwert des durch die Primärwicklung 6 des zweiten Übertragers 2.

Im Zusammenhang mit Mehrleitersystemen kann es notwendig sein, den ersten Übertrager 1 als Nullstromwandler auszuführen. Gemäß Fig. 5 wird die mittlere, auf den magnetischen Weg bezogene Durchflutung des Übertragers 1 durch mehrere stromdurchflossene Primärwicklungen 16 des ersten Übertragers 1 erzeugt. Entsprechend wird auch die mittlere, auf den magnetischen Weg bezogene Durchflutung des zweiten Übertragers 2 durch den Strom in der Primärwicklung 6 des zweiten Übertragers 2 eingestellt, d. h., der Strom in der Primärwicklung 6 entspricht der Summe der vorzeichenrichtig addierten Ströme in den Primärwicklungen 16.

Fig. 6 zeigt eine Schaltungsanordnung, bei der zur Potentialtrennung zwischen Differenzverstärker 7 und Meßkreis ein weiterer Übertrager 17 vorgesehen ist. Dies ist insbesondere dann von Vorteil, wenn die erfindungsgemäße Meßanordnung in Schaltungen Verwendung finden soll, wo mehrere Meßglieder vorhanden sind, die Verstärker aber galvanisch über die Hilfsenergiequelle verbunden sind bzw. sich die Verstärkeranordnung auf einem Potential befindet, welches sowohl vom Potential des zu messenden Stromes als auch vom Potential des repräsentierenden Stromes verschieden ist. Der Meßkreis ist somit galvanisch getrennt.

Es ist auch möglich, die Erfindung auf bereits in Anlagen eingebaute Stromwandler anzuwenden. Der betreffende vorhandene Stromwandler stellt dann den ersten Übertrager 1 dar. Dadurch wird außer einer extrem verbesserten Meßgenauigkeit die Überstromzahl des Wandlers wesentlich erhöht.

**Patentansprüche**

1. Meßanordnung für elektrische Ströme, die aus zwei Übertragern (1, 2) besteht, wobei die Primärwicklung (5) des einen Übertragers (1) vom zu messenden Strom und die Primärwicklung (6) des anderen Übertragers (2) von einem den zu messenden Strom repräsentierenden Strom durchflossen ist, dadurch gekennzeichnet, daß die Übertrager (1, 2) jeweils einen Magnetkern aufweisen und im wesentlichen gleiches Übertragungsverhalten besitzen, die Sekundärwicklungen (3, 4) der beiden Übertrager parallelgeschaltet sind und an den Verbindungspunkten der Sekundärwicklungen (3, 4) ein aktiver Vierpol (7) angeschlossen ist, der von der Differenz der Ströme der Sekundärwicklungen (3, 4) gesteuert wird und den Strom in der Primärwicklung (6) des anderen Übertragers (2) treibt.

2. Meßanordnung nach Anspruch 1, dadurch gekennzeichnet, daß der aktive Vierpol (7) ein Differenzverstärker ist.

3. Meßanordnung für elektrische Ströme, die aus zwei Übertragern (1, 2) besteht, wobei die Primärwicklung (5) des einen Übertragers (1) vom zu messenden Strom und die Primärwicklung (6) des anderen Übertragers (2) von einem den zu messenden Strom repräsentierenden Strom durchflossen ist, dadurch gekennzeichnet, daß die Übertrager (1, 2) jeweils einen Magnetkern und jeweils zwei Sekundärwicklungen (3 und 9 bzw. 4 und 10) aufweisen und im wesentlichen gleiches Übertragungsverhalten besitzen, zwei Sekundärwicklungen (3, 4) der beiden Übertrager (1, 2) parallelgeschaltet sind, und die weiteren Sekundärwicklungen (9, 10) an einem Wicklungserde miteinander verbunden und mit den anderen Wicklungsenden an den Eingang eines aktiven Vierpols (7) gelegt sind, der von der Differenz der in diesen Sekundärwicklungen induzierten Spannung gesteuert wird und den Strom in der Primärwicklung (6) des anderen Übertragers (2) treibt.

4. Meßanordnung nach einem der Ansprüche 1 bis 3, dadurch gekennzeichnet, daß der vom zu messenden Strom durchflossene Übertrager (1) als Einleiterstromwandler mit Ringkern ausgeführt ist.

5. Meßanordnung nach einem der Ansprüche 1, 2 oder 4, dadurch gekennzeichnet, daß zur Gleichstrommessung beide Übertrager (1, 2) je eine Erregerwicklung (11, 12) aufweisen, die von einem Frequenzgenerator (13) gespeist ist.

6. Meßanordnung nach einem der Ansprüche 1 bis 5, dadurch gekennzeichnet, daß in Reihe mit der Primärwicklung (6) des vom den zu messenden Strom repräsentierenden Strom durchflossenen Übertragers (2) ein Wechselstromindikator (8) und/oder eine Gleichrichterbrücke (14) mit Gleichstromindikator (15) geschaltet sind.

7. Meßanordnung nach einem der Ansprüche 1 bis 6, dadurch gekennzeichnet, daß der vom zu messenden Strom durchflossene Übertrager (1) als Nullstromwandler ausgeführt ist.

8. Meßanordnung nach einem der Ansprüche 1 bis 7, dadurch gekennzeichnet, daß ein weiterer, vom aktiven Vierpol (7) gespeister Übertrager (17) vorgesehen ist, dessen Sekundärwicklung in Reihe mit der Primärwicklung (6) des vom den zu messenden Strom repräsentierenden Strom durchflossenen Übertragers (2) liegt.

## Claims

1. Measuring arrangement for electric currents, comprising two transformers (1, 2) wherein the current to be measured flows through the primary winding (5) of the one transformer (1) and a current representing the current to be measured flows through the primary winding (6) of the other transformer (2), characterized in that each of the transformers (1, 2) includes a magnetic core and both have substantially the same transformation characteristic, that the secondary windings (3, 4) of both transformers are connected in parallel, and that an active four-terminal network (7) is connected to the juncture of the secondary windings (3, 4) said network being controlled by the difference between the currents of the secondary windings (3, 4) and driving the current in the primary winding (6) of the other transformer (2).

2. Measuring arrangement according to claim 1, characterized in that the active four-terminal network (7) is a differential amplifier.

3. Measuring arrangement for electric currents, comprising two transformers (1), wherein the current to be measured flows through the primary winding (5) of the one transformer (1) and a current representing the current to be measured flows through the primary winding (6) of the other transformer (2), characterized in that each of the transformers (1, 2) has a magnetic core and two secondary windings (3 and 9, and 4 and 10, respectively) and both have substantially the same transformation characteristic, that two secondary windings (3, 4) of the two transformers (1, 2) are connected in parallel, and that the further secondary windings (9, 10) are interconnected with their one ends while the other winding ends are connected to the input of an active four-terminal network (7) which is controlled by the difference between the voltages induced in these secondary windings and which drives the current in the primary winding (6) of the other transformer (2).

4. Measuring arrangement according to any of the claims 1 to 3, characterized in that the transformer (1) through which the current to be measured flows is designed as a single-wire transformer with a toroidal core.

5. Measuring arrangement according to any of the claims 1, 2 or 4, characterized in that for direct-current measurement each of the two transformers (1, 2) includes an exciting winding (11, 12) supplied by a frequency generator (13).

6. Measuring arrangement according to any of the claims 1 to 5, characterized in that an alternating-current indicator (8) and/or a rectifier bridge circuit (14) including a direct-current indicator (15) is connected in series with the primary winding (6) of the transformer (2) through which the current representing the current to be measured flows.

7. Measuring arrangement according to any of the claims 1 to 6, characterized in that the transformer (1) through which the current to be measured flows is a zero current transformer.

8. Measuring arrangement according to any of the claims 1 to 7, characterized in that a further transformer (7) supplied by the active four-terminal network (7) is provided the secondary winding of which is connected in series to the primary winding (6) of the transformer (2) through which the current representing the current to be measured flows.

## Revendications

1. Dispositif pour la mesure de courants électriques qui se compose de deux transmetteurs (1, 2), l'enroulement primaire (5) de l'un des transmetteurs (1) étant parcouru par le courant à mesurer, tandis que l'enroulement primaire (6) de l'autre transmetteur (2) est parcouru par un courant représentatif du courant à mesurer, dispositif caractérisé en ce que les transmetteurs de courant (1, 2) présentent chacun un noyau magnétique et possèdent des rapports de transmission essentiellement identiques, les enroulements secondaires (3, 4) des deux transmetteurs étant montés en parallèle, et, aux points de liaison des enroulements secondaires (3, 4) est raccordé un quadripôle actif lequel est commandé par la différence des courants des enroulements secondaires (3, 4) et provoque le courant dans l'enroulement primaire (6) de l'autre transmetteur de courant (2).

2. Dispositif de mesure suivant la revendication 1, caractérisé en ce que le quadripôle est constitué par un amplificateur différentiel (7).

3. Dispositif de mesure pour courants électriques consistant en deux transmetteurs de courant (1, 2), l'enroulement primaire (5) de l'un des transmetteurs (1) étant parcouru par le courant à mesurer et l'enroulement primaire (6) de l'autre transmetteur (2) étant parcouru par un courant représentatif du courant à mesurer, dispositif caractérisé en ce que les transmetteurs de courant (1, 2) présentent chacun un noyau magnétique et deux enroulements secondaires (3, 9 et 4, 10) et possèdent un rapport de transmission essentiellement identique, dans des enroulements secondaires (3, 4) des deux transmetteurs (1, 2) étant connectés en parallèle, et les deux autres enroulements secondaires (9, 10) étant reliés entre eux par une extrémité de leur enroulement, et reliés, par les autres extrémités d'enroulements à un quadripôle actif qui est commandé par la différence de tension induite dans ces enroulements secondaires, et qui transmet le courant dans l'enroulement primaire (6) de l'autre transmetteur de courant (2).

4. Dispositif de mesure suivant l'une quelconque des revendications 1 à 3, caractérisé en ce que le transmetteur (1) parcouru par le courant à mesurer est constitué par un convertisseur de courant à conducteur unique avec noyau annulaire.

5. Dispositif de mesure suivant l'une quelconque des revendications 1, 2 ou 4, caractérisé en ce que, pour la mesure de courants continus, les deux transmetteurs de courant (1, 2) sont pourvus chacun d'un enroulement excitateur (11, 12) qui est alimenté par un générateur de fréquence (13).

6. Dispositif de mesure suivant l'une quelconque des revendications 1 à 5, caractérisé en ce que, en série avec l'enroulement primaire (6) du transmetteur (2) parcouru par le courant représentatif du courant à mesurer, est monté un indicateur de courant alternatif (8), et/ou un pont redresseur (14) avec indicateur de courant continu (15).

7. Dispositif de mesure suivant l'une quelconque des revendications 1 à 6, caractérisé en ce que le transmetteur de courant (1) parcouru par le courant à mesurer est constitué par un convertisseur de courant à valeur nulle.

8. Dispositif suivant l'une quelconque des revendications 1 à 7, caractérisé en ce qu'il est prévu un autre transmetteur de courant (17) actionné par quadripôle actif dont l'enroulement secondaire est connecté en série avec l'enroulement primaire (6) du transmetteur de courant (2) qui est parcouru par le courant représentatif du courant à mesurer.

0 029 903

Fig. 1

Fig. 2

Fig. 3

7

Fig. 4

Fig. 5

Fig. 6